# EUROPÄISCHE PATENTSCHRIFT

(11) **EP 2 863 722 B1**
(45) Veröffentlichungstag und Bekanntmachung des Hinweises auf die Patenterteilung: **10.05.2017**
(21) Anmeldenummer: 14400045.2
(22) Anmeldetag: 26.09.2014
(51) Int. Cl.: H05K 5/06

(54) **Elektronikgehäuse**
Electronics housing
Boîtier électronique

(30) Priorität: 16.10.2013 DE 102013017215
(43) Veröffentlichungstag der Anmeldung: 22.04.2015
(73) Patentinhaber: WABCO GmbH, 30453 Hannover (DE)
(72) Erfinder: Kortlang, Tobias, 30989 Gehrden (DE)

(56) Entgegenhaltungen:
- US-A1- 2012 320 531

## Beschreibung

Die Erfindung betrifft ein Elektronikgehäuse mit einem wannenförmigen Gehäuseteil zur Aufnahme einer Leiterplatte mit einer elektronischen Schaltung, bei dem eine Gehäuseöffnung mit einem Bodendeckel abgedichtet verschlossen ist.

Gehäuse zur hermetischen Einkapselung elektronischer Komponenten sind aus dem Stand der Technik in einer großen Variationsbreite bekannt und finden insbesondere zum Schutz von empfindlichen elektronischen Bauteilen vor schädlichen äußeren Umgebungseinflüssen Verwendung. Derartige nachteilige Umgebungseinflüsse können zum Beispiel Vibrationen, extreme Umgebungstemperaturen, Feuchtigkeit, chemisch aggressive Stoffe, Fremdpartikel, elektromagnetische Störfelder oder dergleichen sein, wie sie in Land-, Wasser- und Luftfahrzeugen auftreten. Darüber hinaus ist es bekannt, dass die Gehäuse neben ihrer primären Schutzfunktion für die elektronischen Komponenten zusätzlich die Aufgabe haben, die beim Betrieb der Bauteile unvermeidliche Verlustwärme an die äußere Umgebung abzuführen. Häufig sind derartige Gehäuse aus zwei Schalen mit einer dazwischen liegenden Dichtung aufgebaut, wobei die beiden Gehäusehälften durch eine Schraubverbindung dicht schließend verbunden sind.

Aus der DE 10 2008 016 347 A1 ist ein aus einem Kunststoffmaterial gebildetes Elektronikgehäuse bekannt, bei dem eine Abdeckplatte ein wannenförmiges Gehäuseoberteil zur Schaffung eines Aufnahmeraums dichtend verschließt und die Abdeckplatte mittels einer Rastverbindung befestigt wird. Das Gehäuse verfügt zur Entlüftung über eine gereckte Membran, deren Porendurchmesser den Durchtritt von Luft erlaubt, Wassertröpfen jedoch zurückhält. Aufgrund der komplexen Geometrie des Gehäuseoberteils und der Abdeckplatte sind diese jeweils als Kunststoff-Spritzgussteile ausgeführt, wodurch die Wärmeableitung aus dem Aufnahmeraum erschwert wird. Die komplexe Raumform der Gehäusekomponenten, insbesondere der Abdeckplatte, erschwert darüber hinaus eine rationelle Fertigung der Gehäusekomponenten aus Blech im Wege konventioneller Stanz- und Tiefziehverfahren.

Alternativ dazu kann auch ein wannenförmiges Gehäuseteil mit einem Schraubdeckel und einer Dichtung zum Einsatz kommen. Ein derartiges Gehäuse für eine komplexe elektronische Schaltung mit einem hohen elektrischen Schaltvermögen, wie zum Beispiel einem Steuergerät für ein Antiblockiersystem eines Kraftfahrzeugs oder dergleichen, erfordert jedoch einen metallischen Deckel zur guten Ableitung der im Gehäuse von den elektronischen Bauteilen freigesetzten Verlustwärme. Darüber hinaus lässt sich mit einem metallischen Deckel eine effektive Abschirmung gegenüber elektromagnetischen Störungen erreichen.

Die zur Gewährleistung der Dichtigkeit darüber hinaus erforderliche Dichtgeometrie zwischen dem wannenförmigen Gehäuseteil und dem Deckel wird häufig mittels einer verklebten Nut-/Federverbindung geschaffen. Die Feder einer solchen Dichtgeometrie kann im Tiefziehverfahren wenn überhaupt nur mit einem unvertretbar hohen Aufwand aus einer ebenen Blechtafel gezogen werden, da sich die Feder senkrecht zur Bearbeitungsrichtung erstreckt. Demzufolge ist es üblich, die Blechdeckel derartiger Gehäuse unter Verzicht auf eine komplexe Dichtgeometrie über eine Flachdichtung mit dem anderen Gehäuseteil zu verschrauben.

Ein Nachteil ist darin zu sehen, dass durch die Verschraubung der Montageaufwand des Elektronikgehäuses erhöht ist. Darüber hinaus können sich Schraubverbindungen ohne zusätzliche Sicherungsmaßnahmen leicht lösen, und in Verbindung mit einer möglicherweise auftretenden Setzung der Flachdichtung kann es über die Gebrauchsdauer des Gehäuses hinweg zu Undichtigkeiten kommen.

Das Dokument US2012/0320531 offenbart ein Elektronikgehäuse gemäss dem Oberbegriff des Anspruchs 1. Vor diesem Hintergrund liegt der Erfindung die Aufgabe zugrunde, ein Elektronikgehäuse vorzustellen, dessen Komponenten sich kostengünstig fertigen sowie schraubenlos montieren lassen, und bei dem eine absolut zuverlässige Einkapselung der darin aufgenommenen elektronischen Schaltung zum Schutz vor schädlichen äußeren Umgebungseinflüssen gegeben ist.

Diese Aufgabe wird durch ein Elektronikgehäuse mit den Merkmalen des Anspruchs 1 gelöst. Vorteilhafte Weiterbildungen sind in den Unteransprüchen definiert.

Die Erfindung geht von der Erkenntnis aus, dass sich Schraubverbindungen durch formschlüssige Rast- und Schnappverbindungen ersetzen lassen, und dass Stanz- sowie Tiefziehverfahren, insbesondere zur Großserienfertigung von metallischen Bauteilen vielfach geeigneter sind als Druckgussherstellverfahren.

Die Erfindung betrifft demnach Elektronikgehäuse mit einem wannenförmigen Gehäuseteil zur Aufnahme einer Leiterplatte mit einer elektronischen Schaltung, bei dem eine Gehäuseöffnung mit einem Bodendeckel abgedichtet verschlossen ist.

Zur Lösung der gestellten Aufgabe ist bei diesem Elektronikgehäuse vorgesehen, dass das wannenförmige Gehäuseteil an seinem äußeren Rand einen umlaufenden Flansch aufweist, dass in dem umlaufenden Flansch eine in Richtung zum Bodendeckel offene umlaufende Nut zur Aufnahme eines eine Dichtung bildenden Klebstoffs ausgebildet ist, dass der Bodendeckel aus einem tiefgezogenen Blech besteht, dass der Bodendeckel an seinem äußeren Rand eine zumindest abschnittweise umlaufende Außenkante aufweist, welche in die Nut sowie in die dort angeordnete Dichtung eingreift, dass an dem umlaufenden Flansch des wannenförmigen Gehäuseteils mindestens zwei nach außen gerichtete Laschen ausgebildet sind, dass die Laschen jeweils mindestens einen in Richtung zu der Gehäuseöffnung zeigenden Vorsprung aufweisen, dass an dem äußeren Rand des Bodendeckels mindestens zwei nach außen gerichtete Fortsätze ausgebildet sind, welche die Nut sowie die Dichtung durchsetzen, und dass jeweils mindestens ein Fortsatz zur kraftschlüssigen Verbindung des wannenförmigen Gehäuseteils mit dem Bodendeckel hinter jeweils einem Vorsprung der Laschen federnd einrastbar ist.

Durch diesen Aufbau ist eine schraubenlose Verbindung und zudem eine hermetisch dichte Fügung zwischen dem wannenförmigen Gehäuseteil und dem Bodendeckel realisierbar. Darüber hinaus lässt sich der metallische Bodendeckel des erfindungsgemäßen Elektronikgehäuses einfach sowie kostengünstig durch eine Kombination von bekannten Stanz- und Tiefziehverfahren in großserientauglicher Weise herstellen. Bei der mittels des Elektronikgehäuses eingekapselten elektronischen Schaltung kann es sich beispielsweise um ein Steuergerät für ein Antiblockiersystem eines Kraftfahrzeugs handeln.

Bei einer vorteilhaften Ausgestaltung des Elektronikgehäuses ist vorgesehen, dass eine umlaufende Außenkante des Bodendeckels in einem zusammengebauten Zustand des Elektronikgehäuses im Wesentlichen senkrecht zu einer Oberseite des wannenförmigen Gehäuseteils verläuft. Hierdurch ist vor allem eine einfache und kostengünstige Fertigung des Bodendeckels sowie seiner Außenkante beziehungsweise seines geraden Außenabschnittes gewährleistet, zum Beispiel durch Ausstanzen aus einer ebenen Blechtafel und anschließendes Tiefziehen oder umgekehrt, ohne das Erfordernis von aufwendigen Nachbearbeitungsschritten.

Infolge der bevorzugt näherungsweise eine rechteckförmige Querschnittsgeometrie aufweisenden Nut ist eine verlässliche Lagesicherung des aus einem Klebstoff bestehenden Dichtungsmaterials im umlaufenden Flansch des wannenförmigen Gehäuseteils gegeben.

Gemäß einer weiteren Ausgestaltung weist der Bodendeckel im Bereich seiner Fortsätze jeweils eine näherungsweise V-förmige Querschnittsgeometrie auf. Hierdurch lassen sich die Fortsätze integral am Bodendeckel ausbilden, zum Beispiel durch Tiefziehen. Zudem ist dadurch die mechanische Verwindungssteifigkeit des Bodendeckels verbessert und damit einhergehend die mit diesem erreichbare Abdichtungswirkung optimiert.

Eine andere Ausgestaltung sieht vor, dass das wannenförmige Gehäuseteil mit einem Kunststoffmaterial hergestellt ist, und der Bodendeckel besteht aus einem metallischen Material geringer Dicke, insbesondere aus einem Blech. Hierdurch ist eine hohe mechanische Festigkeit des wannenförmigen Gehäuseteils bei einem zugleich geringen Gewicht und einer ausgezeichneten Korrosionsfestigkeit gegeben. Mit Hilfe einer Faserarmierung lassen sich die mechanischen Eigenschaften des wannenförmigen Gehäuseteils weiter verbessern. Der metallische Bodendeckel erlaubt zudem eine effektive Ableitung der von der elektronischen Schaltung produzierten Verlustwärme, eine gute elektromagnetische Abschirmwirkung sowie einen diffusionsdichten Abschluss der Gehäuseöffnung.

Gemäß einer weiteren Ausgestaltung ist die Dichtung aus einem aus einem dauerhaft elastisch oder hart abbindenden Klebstoff gebildet. Hierdurch ergibt sich eine ausgezeichnete sowie dauerhafte Abdichtungswirkung des Elektronikgehäuses.

Entsprechend einer weiteren Ausgestaltung weist der Bodendeckel mindestens eine wannenförmige Sicke auf. Hierdurch ist die Verwindungssteifigkeit des Bodendeckels weiter erhöht. Zugleich wird der Wärmeübergang zwischen der Leiterplatte, dem Bodendeckel und der äußeren Umgebung beziehungsweise der Atmosphäre erleichtert, und es lassen sich elektronische Bauteile und/oder andere Komponenten mit einer unter Umständen von einer Standardhöhe abweichenden größeren Bauhöhe speziell im Bereich der Sicke auf der Leiterplatte positionieren.

Bevorzugt ist im Bereich der Oberseite des wannenförmigen Gehäuseteils, also deckelfern, mindestens ein elektrischer Steckeranschluss in Form einer Steckerbuchse oder eines geschützten Steckers ausgebildet, dessen Kontaktelemente elektrisch leitend mit der Leiterplatte verbunden sind. Hierdurch kann mittels des Elektronikgehäuses zugleich eine elektrische Anbindung der Leiterplatte und der elektronischen Schaltung beispielsweise an ein elektrisches Bordnetz eines Kraftfahrzeugs erfolgen. Die
elektronische Schaltung ist mit einer Vielzahl von elektronischen und weiteren Bauteilen aufgebaut, die mit Hilfe der Leiterplatte untereinander in geeigneter Weise elektrisch leitend verschaltet sind.

Gemäß einer anderen vorteilhaften Ausgestaltung begrenzen das wannenförmige Gehäuseteil und der Bodendeckel näherungsweise einen quaderförmigen Innenraum des Gehäuses zur Aufnahme der Leiterplatte mit der elektronischen Schaltung. Hierdurch können auch Leiterplatten mit komplexen elektronischen Schaltungen, die neben den rein elektronischen Komponenten auch elektromechanische Bauteile und Kühlkörper umfassen, vom Elektronikgehäuse aufgenommen und hermetisch dicht verkapselt werden.

Zum besseren Verständnis der Erfindung ist der Beschreibung eine Zeichnung beigefügt. In dieser weisen gleiche konstruktive Komponenten jeweils dieselben Bezugsziffern auf. In der Zeichnung zeigt
Fig. 1 eine Ansicht auf die Unterseite eines mit einem Bodendeckel verschlossenen Elektronikgehäuses mit zwei Schnittlinien II-II sowie IV-IV,
Fig. 2 einen Längsschnitt durch das Elektronikgehäuse entlang der Schnittlinie II-II in Fig. 1,
Fig. 3 eine stark vergrößerte Darstellung des Ausschnittes A in Fig. 2,
Fig. 4 einen Längsschnitt durch das Elektronikgehäuse entlang der Schnittlinie IV-IV in Fig. 1, und
Fig. 5 eine stark vergrößerte Darstellung eines Ausschnittes B in Fig. 4.

Das Elektronikgehäuse 10 weist unter anderem ein wannenförmiges Gehäuseteil 12 und einen mit diesem fest verbundenen Bodendeckel 14 auf, welcher das Gehäuseteil 12 unterseitig hermetisch dicht verschließt. Das wannenförmige Gehäuseteil 12 verfügt über einen umlaufenden peripheren Flansch 16, an dem drei nach außen weisende Laschen 18, 20, 22 beziehungsweise Befestigungsaugen ausgebildet sind. In die Laschen 18, 20, 22 ist zur an sich bekannten Befestigung des Elektronikgehäuses 10 an einer anderen Vorrichtung jeweils eine nicht bezeichnete Bohrung eingebracht, durch die jeweils eine Befestigungsschraube hindurchführbar ist.

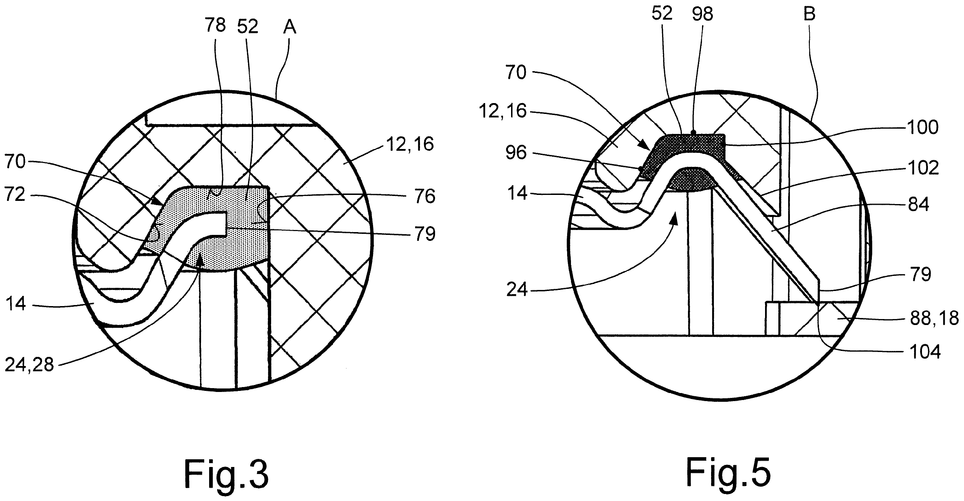

Der umlaufende äußere Rand 24 des Bodendeckels 14 greift zur abgedichteten Befestigung desselben an dem wannenförmigen Gehäuseteil 12 in eine in den Figuren 3 und 5 sichtbare umlaufende Nut 70 des Gehäuseteils 12 ein, welche mit einem vor allem als Dichtung 52 dienenden Klebstoff gefüllt ist. Die Dichtung 52 beziehungsweise der nach seinem Abbinden dauerhaft elastisch oder hart ausgebildete Klebstoff dient vor allem zur hermetischen Abdichtung des Elektronikgehäuses 10 gegenüber der Umgebung 82, er überträgt jedoch auch auf den Bodendeckel 14 wirkende Kräfte in das Gehäuseteil 12.

Der umlaufende Rand 24 des Bodendeckels 14 weist hier exemplarisch drei Zwischenabschnitte 26, 28, 30 auf, die jeweils zwischen zwei benachbarten Laschen 18, 20; 20, 22; 22, 18 beziehungsweise zwischen hier nicht vollständig sichtbaren, nach außen gerichteten Fortsätzen 84, 86 des Bodendeckels 14 verlaufen.

Im Bodendeckel 14 sind darüber hinaus Sicken 32, 34, 36, 38 ausgeformt, die unter anderem zur mechanischen Verstärkung sowie zur Optimierung der Wärmeableitung aus dem Elektronikgehäuse 10 dienen.

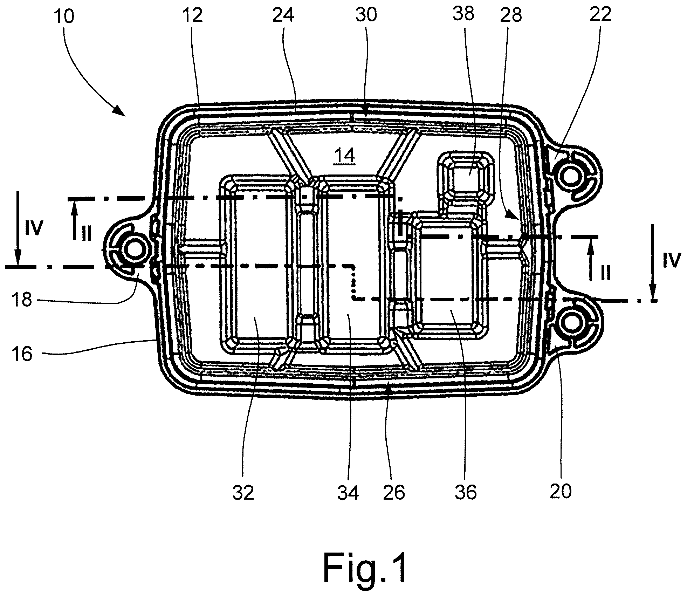

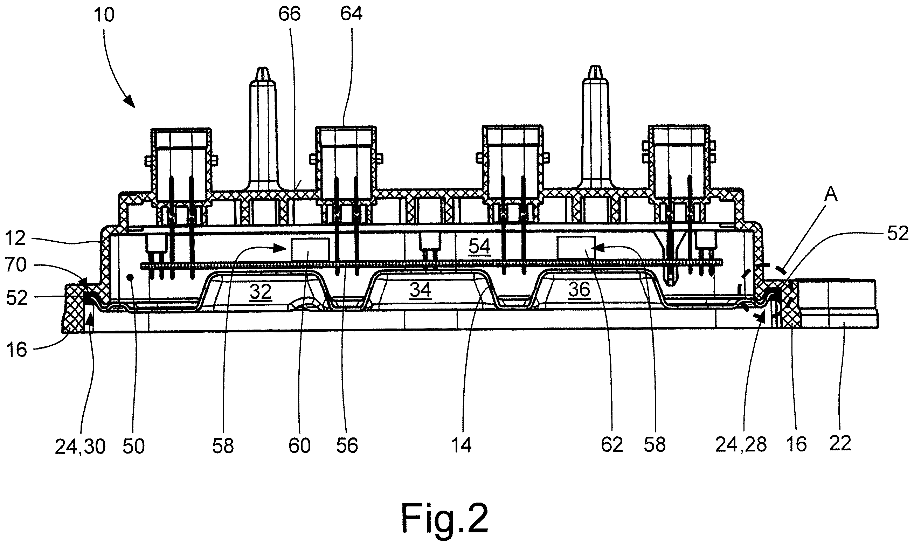

Fig. 2 zeigt einen Längsschnitt durch das Elektronikgehäuse 10 entlang der Schnittlinie II-II in Fig. 1. Eine unterseitige Gehäuseöffnung 50 des wannenförmigen Gehäuseteils 12 ist mittels des Bodendeckels 14 verschlossen. Dazu greift der äußere Rand 24 des Bodendeckels 14 in die umlaufende Nut 70 im peripheren Flansch 16 des Gehäuseteils 12 ein, in welcher die aus einem Klebstoff bestehende Dichtung 52 angeordnet ist. Wie insbesondere die Vergrößerung der Nut 70 in Fig. 3 zeigt, umgreift die Dichtung 52 die umlaufende Außenkante 79 des Bodendeckels 14 randseitig vollständig, woraus eine gute Halte- und Abdichtungswirkung am Elektronikgehäuse 10 resultiert.

Das wannenförmige Gehäuseteil 12 mit den daran angeformten, nach außen weisenden Laschen 18, 20, 22 begrenzt zusammen mit dem Bodendeckel 14 einen ungefähr quaderförmigen Innenraum 54, in dem eine ebene Leiterplatte 56 mit einer elektronischen Schaltung 58 angeordnet ist. Die elektronische Schaltung 58 umfasst hier lediglich beispielhaft zwei elektronische Bauteile 60, 62, die mittels der Leiterplatte 56 miteinander elektrisch verschaltet sowie elektrisch leitend mit einem Steckeranschluss 64 in Form einer Steckerbuchse verbunden sind, welcher im Bereich der Oberseite 66 des Gehäuseteils 12 ausgebildet ist. Die elektronische Schaltung 58 kann neben den hier lediglich exemplarisch gezeigten beiden elektronischen Bauteilen 60, 62 eine Vielzahl von weiteren aktiven oder passiven elektronischen, elektromechanischen und mechanischen Bauteilen umfassen, wie beispielsweise Relais, Magnetventile, Schalter, Taster, Kühlkörper, Motoren, Lüfter oder dergleichen. Im Bereich der Oberseite 66 des Gehäuseteils 12 sind weitere, nicht mit Bezugsziffern versehene Steckeranschlüsse ausgebildet, die gleichfalls mit der elektronischen Schaltung 58 elektrisch verbunden sind, und deren konstruktiver Aufbau jeweils dem des Steckeranschlusses 64 entspricht.

Das wannenförmige Gehäuseteil 12 ist bevorzugt aus einem faserverstärkten duroplastischen oder thermoplastischen Kunststoffmaterial gebildet, um eine hohe mechanische Belastbarkeit des Elektronikgehäuses 10 bei einem zugleich geringen Gewicht und einer guten Korrosionsfestigkeit zu erzielen. Der Bodendeckel 14 ist vorzugsweise einstückig aus einem metallischen Material, insbesondere aus einem Blech, gefertigt und kann zum Beispiel durch Ausstanzen und anschließendes Tiefziehen auf einfache Art und Weise aus einer ebenen Blechtafel in großserientauglicher Weise hergestellt werden.

Die Dichtung 52 ist aus einem Klebstoff oder einem anderen zunächst zumindest pastösen Kunststoff gebildet, der vorzugsweise bei Raumtemperatur an der Umgebungsluft soweit abbindet oder aushärtet, dass dieser nicht aus der genannten Nut des wannenförmigen Gehäuseteils 12 austritt. Als Klebstoff können beispielsweise Epoxydharz, Polyesterharz oder dauerelastisch aushärtende Kunststoffe, wie beispielsweise Polyurethan oder Silikon, zur Anwendung kommen. Die klebende Dichtung 52 verbindet demnach den Flansch 16 des Gehäuseteils 12 mit dem Bodendeckel 14. Sie kann zur Verbesserung ihrer mechanischen Eigenschaften mit Fasern armiert sein.

Fig. 3 zeigt eine stark vergrößerte Darstellung des Ausschnitts A in Fig. 2. Im umlaufenden peripheren Flansch 16 des wannenförmigen Gehäuseteils 12 ist die schon genannte Nut 70 mit einer näherungsweise rechteckförmigen Querschnittsgeometrie zur Aufnahme der aus einem Klebstoff gebildeten Dichtung 52 angeordnet. Die Nut 70 verfügt im Bereich des Zwischenabschnitts 28 des Bodendeckels 14 und in allen weiteren Zwischenabschnitten 26, 30 desselben über eine geringfügig schräg gestellte Seitenwand 72, die in einen horizontalen Nutgrund 78 übergeht, an den sich eine lotrechte, demnach rechtwinklig zur hier nicht dargestellten Oberseite 66 des wannenförmigen Gehäuseteils 12 (siehe Fig. 2) verlaufende Seitenwand 76 anschließt.

Der Rand 24 des Bodendeckels 14 wird im vorliegenden Ausführungsbeispiel von der Dichtung 52 vollständig umgriffen, so dass die umlaufende Außenkante 79 des Bodendeckels 14 vollständig in die Dichtung 52 eingefügt ist, ohne die Wände 72, 76, 78 der Nut 70 zu berühren. Der Zwischenabschnitt 28 am Rand 24 des Bodendeckels 14 weist eine näherungsweise viertelkreisringförmige Querschnittsgeometrie auf. Die umlaufende Außenkante 79 beziehungsweise ein gerader Außenabschnitt des Bodendeckels 14 verläuft ebenfalls ungefähr senkrecht zu der hier nicht dargestellten Oberseite 66 des wannenförmigen Gehäuseteils 12, so dass sich der Bodendeckel 14 als einfaches, einstückiges Stanz- und/oder Tiefziehformteil ohne das Erfordernis von aufwendigen Nachbearbeitungsschritten, wie beispielsweise an metallischen Druckgussteilen üblichen Entgratungsarbeiten, schnell und kostenoptimal herstellen lässt.

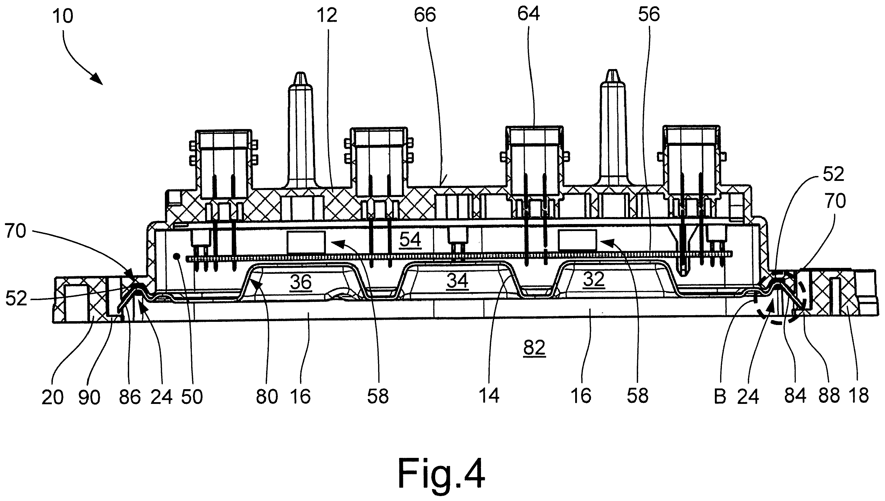

Fig. 4 zeigt einen Längsschnitt durch das Elektronikgehäuse 10 entlang der Schnittlinie IV-IV in Fig. 1. Durch das wannenförmige Gehäuseteil 12 ist zusammen mit dem Bodendeckel 14 und der Dichtung 52 der hermetisch abgekapselte Innenraum 54 des Elektronikgehäuses 10 zur Aufnahme der Leiterplatte 56 mit der elektronischen Schaltung 58 definiert. Der im Bereich der horizontal verlaufenden Oberseite 66 des wannenförmigen Gehäuseteils 12 ausgebildete elektrische Steckeranschluss 64 ist wiederum mit der Leiterplatte 56 sowie der mittels dieser aufgebauten elektronischen Schaltung 58 elektrisch leitend verbunden. Die Sicken 32, 34, 36 sowie die weitere, hier nicht sichtbare Sicke 38 erhöhen die Verwindungssteifigkeit des Bodendeckels 14 und damit die Abdichtungswirkung des Elektronikgehäuses 10. Darüber hinaus bewirken die Sicken 32, 34, 36, 38 eine Vergrößerung einer Außenfläche 80 des Bodendeckels 14, wodurch die Ableitung der von der elektronischen Schaltung 58 im Einzelfall freigesetzten Verlustwärme an die äußere Umgebung 82 des Elektronikgehäuses 10 erleichtert wird.

Der Bodendeckel 14 weist an seinem umlaufenden Rand 24 im Bereich der Laschen 18, 20 jeweils einen nach außen gerichteten sowie einstückig mit dem Bodendeckel 14 ausgebildeten federnden Fortsatz 84, 86 auf. In dem in den Figuren gezeigten geschlossenen Zustand des Elektronikgehäuses 10 sind diese Fortsätze 84, 86 hinter zwei kleinen, im Querschnitt quaderförmigen Vorsprüngen 88, 90 eingerastet, welche integral an den jeweiligen Laschen 18, 20 ausgebildet sind sowie im Wesentlichen in Richtung des Innenraumes 54 weisen. Auch im Bereich der in dieser Darstellung nicht sichtbaren dritten Lasche 22 ist ein derartiger Fortsatz am Bodendeckel 14 ausgebildet, der hinter einem an der dritten Lasche 22 ausgebildeten, gleichfalls in Fig. 4 nicht sichtbaren Vorsprung eingerastet ist.

Beim Eindrücken des Bodendeckels 14 in die vom umlaufenden Flansch 16 des wannenförmigen Gehäuseteils 12 umgrenzte unterseitige Gehäuseöffnung 50 rasten die Fortsätze 84, 86 selbsttätig hinter den Vorsprüngen 88, 90 der Laschen 18, 20 ein, wodurch im Vergleich zu einem verschraubten Bodendeckel eine schnellere Montage des Elektronikgehäuses 10 möglich ist. Darüber hinaus erreicht diese Rastverbindung zwischen dem wannenförmigen Gehäuseteil 12 und dem Bodendeckel 14 auch ohne weitere Sicherungsmaßnahmen, wie sie bei Schraubverbindungen in der Regel notwendig sind, eine hohe Vibrationsresistenz. Dazu trägt entscheidend auch die in der umlaufenden Nut 70 angeordnete, aus einem Klebstoff bestehende Dichtung 52 bei, welche während des Zusammenbaus des Elektronikgehäuses 10 zunächst klebrig viskos ist und ein Eintauchen des umlaufenden Randes 24 des Bodendeckels 14 in denselben ermöglicht, nach Beendigung der Montage des Elektronikgehäuses 10 jedoch schnell sowie mit oder ohne einer verbleibenden Elastizität aushärtet, und so den Bodendeckel 14 am Gehäuseteil 12, vorzugsweise lösbar, fixiert.

Infolge der beschriebenen kraftschlüssigen und bereichsweise formschlüssigen Verbindung ergibt sich im Zusammenwirken mit der dauerelastischen oder vollständig ausgehärteten Dichtung 52 darüber hinaus eine gute Abdichtwirkung zwischen dem Gehäuseteil 12 und dem Bodendeckel 14, so dass die Leiterplatte 56 mit der elektronischen Schaltung 58 dauerhaft vor schädlichen Einflüssen aus der äußeren atmosphärischen Umgebung 82 geschützt ist.

Fig. 5 zeigt eine stark vergrößerte Darstellung eines Ausschnitts B in Fig. 4. Die Dichtung 52 ist auch an dieser Stelle in der Nut 70 angeordnet, welche im Bereich des Fortsatzes 84 des Bodendeckels 14 und der übrigen Fortsätze des Bodendeckels 14 wiederum eine im Wesentlichen rechteckförmige Querschnittsgeometrie aufweist. In den Bereichen der Fortsätze 84 verfügt die Nut 70 entsprechend zur Geometrie in den Zwischenabschnitten (siehe insbesondere Fig. 3) ebenfalls über eine geringfügig schräg gestellte Seitenwand 96, an die sich ein horizontal verlaufender Nutgrund 98 anschließt, der in einen lotrechten Seitenwandabschnitt 100 übergeht. Im Unterschied zur Nutgeometrie in den Zwischenabschnitten des Bodendeckels der Fig. 3 schließt sich an diesen halbhohen, senkrechten Seitenwandabschnitt 100 noch ein geneigter Seitenwandabschnitt 102 mit größerer Höhe an, der entgegengesetzt geneigt zur Seitenwand 96 ausgebildet ist und die geneigte Seitenwand 96 geringfügig überragt.

Erkennbar ist der nach oben gewölbte Randbereich 24 des Bodendeckels 14 derartig in das Material der Dichtung 52 eingesetzt, dass die Nutwände 96, 98, 100 nicht berührt werden, wodurch eine vollständige Abdichtung des Innenraumes 54 des Elektronikgehäuses 10 gewährleistet ist.

Der geneigte Seitenwandabschnitt 102 schafft denjenigen radialen Raum innerhalb des Flansches 16 des wannenförmigen Gehäuseteils 12, welcher zum Ein- und Ausfedern des Fortsatzes 84 und aller weiteren Fortsätze des Bodendeckels 14 beim Verrasten des Bodendeckels 14 mit dem wannenförmigen Gehäuseteil 12 notwendig ist. Der Fortsatz 84 sowie alle weiteren Fortsätze im Rand 24 des Bodendeckels 14 verfügen über eine angenähert asymmetrische V-förmige Querschnittsgeometrie.

In der in Fig. 5 dargestellten Situation ist der Bodendeckel 14 mit dem wannenförmigen Gehäuseteil 12 verrastet, wobei der Fortsatz 84 hinter dem an der Lasche 18 angeformten Vorsprung 88 des Flansches 16 des wannenförmigen Gehäuseteils 12 zur Anlage gekommen ist. Die umlaufende Außenkante 79 des Bodendeckels 14 verläuft auch im Bereich der Fortsätze 84 senkrecht, also im Wesentlichen rechtwinklig zu der hier nicht dargestellten Oberseite 66 des wannenförmigen Gehäuseteils 12. Hierdurch entsteht in Verbindung mit der V-förmigen Querschnittsgeometrie des Bodendeckels 14 im Bereich der Fortsätze 84 eine spitzwinklige Kante104, die sich im geschlossenen Zustand des Elektronikgehäuses 10 zumindest bereichsweise in das Material des Vorsprungs 88 der Lasche 18 eingräbt beziehungsweise sich in diesem zumindest bereichsweise formschlüssig festsetzt, so dass ein zuverlässiger, insbesondere vibrationsresistenter Sitz des Bodendeckels 14 innerhalb der unterseitigen Gehäuseöffnung des wannenförmigen Gehäuseteils 12 gewährleistet ist.

Darüber hinaus vereinfacht die senkrechte Geometrie der Außenkante 79 beziehungsweise des geraden Abschnitts des Bodendeckels 14 den Herstellungsprozess des Bodendeckels 14 im Wege bekannter Stanz- und/oder Tiefziehverfahren, da ansonsten notwendige und in der Regel aufwendige Nachbearbeitungsschritte entfallen können.

Nach dem Verrasten des Bodendeckels 14 mit dem wannenförmigen Gehäuseteil 12 kann das Elektronikgehäuse 10 unter Einsatz eines geeigneten Werkzeugs erforderlichenfalls auch wieder geöffnet werden. Hierbei werden der Fortsatz 84 und alle weiteren Fortsätze 84 radial nach innen gebogen, also in Richtung zu der unterseitigen Gehäuseöffnung 50 des Gehäuseteils 12, und von den Vorsprüngen 88, 90, abgehoben. Diese Ausrastbewegung der Fortsätze 84 kann gegebenenfalls durch die Ausübung einer zentrisch und in Richtung des wannenförmigen Gehäuseteils 12 auf den Bodendeckel 14 einwirkenden mechanischen Druckkraft, die zu einer Durchbiegung des Bodendeckels 14 und einer damit einhergehenden Kompression der Dichtung 52 führt, unterstützt werden.

## Patentansprüche

1. Elektronikgehäuse (10) mit einem wannenförmigen Gehäuseteil (12) zur Aufnahme einer Leiterplatte (56) mit einer elektronischen Schaltung (58), bei dem eine Gehäuseöffnung (50) mit einem Bodendeckel (14) abgedichtet verschlossen ist, wobei der Bodendeckel aus einem tiefgezogenen Blech besteht, **dadurch gekennzeichnet,**
- **dass** das wannenförmige Gehäuseteil (12) an seinem äußeren Rand einen umlaufenden peripheren Flansch (16) aufweist,
- **dass** in dem umlaufenden Flansch (16) eine in Richtung zum Bodendeckel (14) offene umlaufende Nut (70) zur Aufnahme eines eine Dichtung (52) bildenden Klebstoffs ausgebildet ist,
- **dass** der Bodendeckel (14) an seinem äußeren Rand (24) eine zumindest abschnittweise umlaufende Außenkante (79) aufweist, welche in die Nut (70) sowie in die dort angeordnete Dichtung (52) eingreift,
- **dass** an dem umlaufenden Flansch (16) mindestens zwei nach außen gerichtete Laschen (18, 20, 22) ausgebildet sind,
- **dass** die Laschen (18, 20, 22) jeweils mindestens einen in Richtung zu der Gehäuseöffnung (50) zeigenden Vorsprung (88, 90) aufweisen,
- **dass** an dem äußeren Rand (24) des Bodendeckels (14) mindestens zwei nach außen gerichtete Fortsätze (84, 86) ausgebildet sind, welche die Nut (70) sowie die Dichtung (52) durchsetzen,
- und **dass** jeweils mindestens ein Fortsatz (84, 86) zur kraftschlüssigen Verbindung des wannenförmigen Gehäuseteils (12) mit dem Bodendeckel (14) hinter jeweils einem Vorsprung (88, 90) der Laschen (18, 20, 22) federnd einrastbar ist.

2. Elektronikgehäuse nach Anspruch 1, **dadurch gekennzeichnet, dass** die umlaufende Außenkante (79) des Bodendeckels (14) in einem zusammengebauten Zustand des Elektronikgehäuses (10) im Wesentlichen senkrecht zu einer Oberseite (66) des wannenförmigen Gehäuseteils (12) verläuft.

3. Elektronikgehäuse nach Anspruch 1 oder 2, **dadurch gekennzeichnet, dass** der Bodendeckel (14) im Bereich seiner Fortsätze (84, 86) jeweils eine näherungsweise
V-förmige Querschnittsgeometrie aufweist.

4. Elektronikgehäuse nach einem der Ansprüche 1 bis 3, **dadurch gekennzeichnet, dass** das wannenförmige Gehäuseteil (12) mit einem Kunststoffmaterial gebildet ist.

5. Elektronikgehäuse nach einem der Ansprüche 1 bis 4, **dadurch gekennzeichnet, dass** die Dichtung (52) aus einem dauerhaft elastisch abbindenden Klebstoff besteht.

6. Elektronikgehäuse nach einem der Ansprüche 1 bis 4, **dadurch gekennzeichnet, dass** die Dichtung (52) aus einem hart abbindenden Klebstoff besteht.

7. Elektronikgehäuse nach einem der Ansprüche 1 bis 6, **dadurch gekennzeichnet, dass** der Bodendeckel (14) mindestens eine wannenförmige Sicke (32, 34, 36, 38) aufweist.

8. Elektronikgehäuse nach einem der Ansprüche 1 bis 7, **dadurch gekennzeichnet, dass** im Bereich der Oberseite (66) des wannenförmigen Gehäuseteils (12) mindestens ein elektrischer Steckeranschluss (64) vorgesehen ist, der elektrisch leitend mit der Leiterplatte (56) verbunden ist.

9. Elektronikgehäuse nach einem der Ansprüche 1 bis 8, **dadurch gekennzeichnet, dass** das wannenförmige Gehäuseteil (12) und der Bodendeckel (14) näherungsweise einen quaderförmigen Innenraum (54) zur Aufnahme der Leiterplatte (56) mit der elektronischen Schaltung (58) begrenzen.

## Claims

1. Electronics housing (10) comprising a tub-like housing part (12) for accommodating a printed circuit board (56) with an electronic circuit (58), in which electronics housing a housing opening (50) is closed in a sealed off manner by a base cover (14), wherein the base cover consists of a deep-drawn metal sheet,
**characterized**
- **in that** the tub-like housing part (12) has a circumferential peripheral flange (16) on its outer border,
- **in that** a circumferential groove (70) which is open in the direction of the base cover (14) is formed in the circumferential flange (16) for receiving an adhesive which forms a seal (52),
- **in that** the base cover (14) has an outer edge (79), which is circumferential at least in sections and which engages into the groove (70) and also into the seal (52) arranged there, on its outer border (24),
- **in that** at least two lugs (18, 20, 22), which are directed outwards, are formed on the circumferential flange (16),
- **in that** the lugs (18, 20, 22) each have at least one projection (88, 90) which points in the direction of the housing opening (50),
- **in that** at least two projections (84, 86), which are directed outwards and which pass through the groove (70) and also the seal (52), are formed on the outer border (24) of the base cover (14),
- and **in that** in each case at least one projection (84, 86) for connecting the tub-like housing part (12) to the base cover (14) in a force-fitting manner can latch in with a spring action behind in each case one projection (88, 90) of the lugs (18, 20, 22).

2. Electronics housing according to Claim 1, **characterized in that** the circumferential outer edge (79) of the base cover (14), in the assembled state of the electronics housing (10), runs substantially perpendicular to a top side (66) of the tub-like housing part (12).

3. Electronics housing according to Claim 1 or 2, **characterized in that** the base cover (14), in the region of its projections (84, 86), has in each case one approximately V-shaped cross-sectional geometry.

4. Electronics housing according to one of Claims 1 to 3, **characterized in that** the tub-like housing part (12) is formed with a plastic material.

5. Electronics housing according to one of Claims 1 to 4, **characterized in that** the seal (52) consists of a permanently elastically setting adhesive.

6. Electronics housing according to one of Claims 1 to 4, **characterized in that** the seal (52) consists of a hard-setting adhesive.

7. Electronics housing according to one of Claims 1 to 6, **characterized in that** the base cover (14) has at least one tub-like bead (32, 34, 36, 38).

8. Electronics housing according to one of Claims 1 to 7, **characterized in that** at least one electrical plug connection (64) which is electrically conductively connected to the printed circuit board (56) is provided in the region of the top side (66) of the tub-like housing part (12).

9. Electronics housing according to one of Claims 1 to 8, **characterized in that** the tub-like housing part (12) and the base cover (14) approximately delimit a cuboidal interior (54) for accommodating the printed circuit board (56) with the electronic circuit (58).

## Revendications

1. Boîtier électronique (10) comprenant une partie de boîtier (12) en forme de cuvette destinée à accueillir un circuit imprimé (56) équipé d'un circuit électronique (58), avec lequel une ouverture de boîtier (50) est fermée hermétiquement avec un couvercle de fond (14), le couvercle de fond se composant d'une tôle emboutie,
**caractérisé en ce**
- **que** la partie de boîtier (12) en forme de cuvette possède sur son bord extérieur une bride périphérique (16) périphérique,
- **qu'**une rainure (70) périphérique, ouverte en direction du couvercle de fond (14) et destinée à accueillir un adhésif formant une garniture d'étanchéité (52), est formée dans la bride (16) périphérique,
- **que** le couvercle de fond (14) possède sur son bord extérieur (24) une arête extérieure (79) périphérique au moins dans certaines portions, laquelle vient en prise dans la rainure (70) ainsi que dans la garniture d'étanchéité (52) qui y est disposée,
- **qu'**au moins deux languettes (18, 20, 22) dirigées vers l'extérieur sont formées sur la bride périphérique (16),
- **que** les languettes (18, 20, 22) possèdent respectivement au moins une partie en saillie (88, 90) qui pointe en direction de l'ouverture de boîtier (50),
- **qu'**au moins deux prolongements (84, 86) dirigés vers l'extérieur sont formés sur le bord extérieur (24) du couvercle de fond (14), lesquels entrecoupent la rainure (70) ainsi que la garniture d'étanchéité (52),
- et **qu'**au moins un prolongement (84, 86) peut respectivement être encliqueté par effet ressort derrière une partie en saillie (88, 90) respective des languettes (18, 20, 22) en vue de réaliser un assemblage par force de la partie de boîtier (12) en forme de cuvette avec le couvercle de fond (14).

2. Boîtier électronique selon la revendication 1, **caractérisé en ce que** l'arête extérieure (79) périphérique du couvercle de fond (14), lorsque le boîtier électronique (10) est à l'état assemblé, s'étend pour l'essentiel perpendiculairement à un côté supérieur (66) de la partie de boîtier (12) en forme de cuvette.

3. Boîtier électronique selon la revendication 1 ou 2, **caractérisé en ce que** le couvercle de fond (14) possède, dans la zone de ses prolongements (84, 86), une géométrie de section transversale approximativement en forme de V.

4. Boîtier électronique selon l'une des revendications 1 à 3, **caractérisé en ce que** la partie de boîtier (12) en forme de cuvette est formée par une matière plastique.

5. Boîtier électronique selon l'une des revendications 1 à 4, **caractérisé en ce que** la garniture d'étanchéité (52) se compose d'un adhésif à prise à élasticité permanente.

6. Boîtier électronique selon l'une des revendications 1 à 4, **caractérisé en ce que** la garniture d'étanchéité (52) se compose d'un adhésif à prise dure.

7. Boîtier électronique selon l'une des revendications 1 à 6, **caractérisé en ce que** le couvercle de fond (14) possède au moins une moulure (32, 34, 36, 38) en forme de cuvette.

8. Boîtier électronique selon l'une des revendications 1 à 7, **caractérisé en ce qu'**au moins une borne à enficher (64) électrique se trouve dans la zone du côté supérieur (66) de la partie de boîtier (12) en forme de cuvette, laquelle est reliée de manière électriquement conductrice avec le circuit imprimé (56).

9. Boîtier électronique selon l'une des revendications 1 à 8, **caractérisé en ce que** la partie de boîtier (12) en forme de cuvette et le couvercle de fond (14) délimitent approximativement un espace intérieur (54) parallélépipédique destiné à accueillir le circuit imprimé (56) équipé du circuit électronique (58) .
